# EUROPÄISCHE PATENTSCHRIFT

(11) **EP 2 649 376 B1**
(45) Veröffentlichungstag und Bekanntmachung des Hinweises auf die Patenterteilung: **07.02.2018**
(21) Anmeldenummer: 11788866.9
(22) Anmeldetag: 01.12.2011
(51) Int. Cl.: F24C 7/08, A47L 15/42, B60K 37/06, D06F 39/00, G05G 1/08, G09F 9/00, H03K 17/965, G06F 3/0488, G06F 3/0484, G09F 23/00

(54) **VERFAHREN ZUR STEUERUNG EINES GERÄTES UND BEDIENEINRICHTUNG DAFÜR**
METHOD FOR CONTROLLING AN APPLIANCE AND OPERATOR CONTROL DEVICE THEREFOR
PROCÉDÉ DE COMMANDE D'UN APPAREIL ET SYSTÈME DE MANIPULATION APPROPRIÉ

(30) Priorität: 06.12.2010 DE 102010062485
(43) Veröffentlichungstag der Anmeldung: 16.10.2013
(73) Patentinhaber: E.G.O. Elektro-Gerätebau GmbH, 75038 Oberderdingen (DE)
(72) Erfinder: ROTH, Bernhard, 33613 Bielefeld (DE)
(74) Vertreter: Patentanwälte Ruff, Wilhelm, Beier, Dauster & Partner mbB
(86) Internationale Anmeldenummer: PCT/EP2011/071510
(87) Internationale Veröffentlichungsnummer: WO 2012/076395

(56) Entgegenhaltungen:
- EP-A2- 2 224 174
- CH-A1- 700 524
- DE-A1-102005 004 337
- DE-A1-102008 032 450
- DE-A1-102009 011 678
- US-A1- 2002 045 142
- US-A1- 2005 078 027
- US-A1- 2007 236 476
- US-A1- 2009 189 869

## Beschreibung

### Anwendungsgebiet und Stand der Technik

Die Erfindung betrifft ein Verfahren zur Steuerung eines Geräts mit einer Bedieneinrichtung mit Bedienfläche.

Beispielsweise aus der EP 1 344 983 A2 ist ein Kochfeld als Gerät bekannt mit einer Bedieneinrichtung, an deren Bedienfläche eine Kochstelle über ein Bedienelement ausgewählt werden kann. Mit anderen Bedienelementen an der Bedienfläche kann dann dieser ausgewählten Kochstelle eine Leistungsstufe als Betriebswert zugeordnet werden, beispielsweise durch Betätigen einer Plus- und/oder Minus-Taste.

Aus der DE 10 2005 035 543 A1 ist es bekannt, dieses Verfahren sozusagen umzudrehen und dabei zuerst eine Leistungsstufe einzustellen und dann die ausgewählte Leistungsstufe einer bestimmten Kochstelle zuzuordnen. Hierfür sind ebenfalls jeweils unterschiedliche Bedienelemente, die einzeln bedient werden, vorgesehen.

Aus der CH 700 524 A1 ist eine berührungslose Gestenbedienung eines Geräts bekannt.

Aus der DE 10 2009 011 678 A1 ist es bekannt, an einer Bedieneinrichtung einer Waschmaschine durch eine erste Bewegung in vertikaler Richtung eine Temperatur von beispielsweise 90°C auszuwählen. Dann wird diese Temperatur für einen Betrieb ausgewählt.

Aus der US 2002/0045142 A1 ist eine Bedienung mit Berührungsschaltern an einer Bedienfläche bekannt mit einem sogenannten Slider, die somit eine Bedienung mit einem Bewegungszug durch einen aufgelegten Finger ermöglicht. Dabei wird nur diese eine Bewegung vorgesehen und keine weiterführende Bewegung oder zweite Bewegung.
Aus der DE 10 2008 032 450 A1 sind für ein Gargerät allgemein mehrere Möglichkeiten zur Bedienung mit einer Bedienfläche und Berührungsschaltern daran bekannt.
Aus der EP 2 224 174 A2 ist es bekannt, bei einer Dunstabzugshaube als Elektrogerät einen länglichen Berührschalter als sogenannter Slider vorzusehen. Damit kann durch Darüberstreichen mit einem Finger eine Licht-Lichtleistung oder eine Belüftungsleistung eingestellt werden.
Aus der DE 10 2005 004 337 A1 ist eine Bedieneinrichtung bekannt, bei der durch Darüberstreichen mit einem Finger als eine durchgezogene Bewegung ein Kochfeld betätigt werden kann. Die Bewegung kann von einem zentralen Berührsensor zu einem äußeren Berührsensor gehen. Aus der US 2005/0078027 A1 ist eine weitere Bedieneinrichtung mit einem Slider für ein Kochfeld bekannt, der durch Darüberstreichen mit einem Finger betätigt werden kann. Dabei ist eine Bewegung nur in der Längsrichtung möglich.
Aus der US 2009/0189689 A1 ist eine weitere Bedieneinrichtung für ein Elektrogerät bekannt, bei der ein Finger in einer auf eine Bedienfläche aufgesetzten Bewegung mehrere Funktionen durch Einstellen von Symbolen einstellt. Dabei wird der Finger in einer aufgesetzten und ununterbrochenen Bewegung von Symbol zu Symbol bewegt, wobei die verschiedenen Symbole in verschiedenen Spalten angeordnet sind. Dabei muss der Finger auf jedem der Symbole zu liegen kommen zu dessen Auswahl. Das aus diesem Dokument bekannte Verfahren wird als nächstliegender Stand der Technik angesehen. Aus der US 2007/0236476 A1 ist eine Bedieneinrichtung bekannt mit einem Touchpad als eine Art Berührbildschirm. Hier können verschiedene Fingerbewegungen durchgeführt werden, um sogenannte Pulldown-Menüs auszulösen mit jeweils mehreren Menüpunkten. Zu jedem dieser Menüpunkte kann ein Untermenü aufgerufen werden. Dabei muss der Finger stets auf der Oberfläche der Bedieneinrichtung verweilen, damit eine Auswahl bzw. Ansehen und auch ein Aktivieren möglich ist.

### Aufgabe und Lösung

Der Erfindung liegt die Aufgabe zugrunde, ein eingangs genanntes Verfahren zu schaffen, mit dem Probleme des Standes der Technik vermieden werden können und es insbesondere möglich ist, ein komfortables und vielseitiges sowie intuitiv verständiges Bedienverfahren bereitzustellen.

Gelöst wird diese Aufgabe durch ein Bedienverfahren mit den Merkmalen des Anspruchs 1. Vorteilhafte sowie bevorzugte Ausgestaltungen des Erfindungsgegenstandes sind Gegenstand der weiteren Ansprüche und werden im Folgenden näher erläutert. Der Wortlaut der Ansprüche wird durch ausdrückliche Bezugnahme zum Inhalt der Beschreibung gemacht.

Es ist vorgesehen, dass auf einer Bedienfläche einer Bedieneinrichtung des Gerätes ein erstes Symbol für einen ersten Betriebswert einer ersten Funktion dargestellt wird, beispielsweise eine Leistungsstufe einer elektrischen Funktionseinheit wie beispielsweise einer Heizeinrichtung oder Kochstelle.

Gemäß der Erfindung zum Einstellen und Zuordnen zweier Funktionen wird durch Längsbewegung entlang einer Linie, die vorzugsweise eine gerade Linie ist, der erste Betriebswert der ersten Funktion dann eingestellt bzw. dadurch eingestellt, wenn der Finger in einer auf die Bedienfläche aufgesetzten Bewegung das erste Symbol erreicht als erster Bewegungszug. Dann wird durch eine weiterführende Bewegung als zweiten Bewegungszug ohne Abnehmen des Fingers in einer Richtung, welche einen Winkel zwischen 30° und 150° zur bisherigen Bewegungsrichtung aufweist, der Finger weiterbewegt auf ein zweites Symbol zu, das auch auf der Bedienfläche dargestellt ist. Dies dient dazu, die eingestellte erste Funktion zu der Funktionsbedeutung dieses zweiten Symbols zuzuordnen. Im Prinzip wird hier also die Bedienbewegung beim zweiten Symbol durchgeführt bzw. für die zweite Funktion durchgeführt ähnlich wie zuvor beschrieben für die erste grundsätzliche Ausgestaltung. Der Unterscheid liegt hier eben in der anderen Einstellung des ersten Betriebswertes der ersten Funktion, also quasi im ersten Bewegungszug.

Gemäß der Erfindung kann eine fließende Bedienbewegung mit einem Finger auf der Bedienfläche durchgeführt werden, die quasi aus zwei aneinander anschließenden Linien bzw. Bewegungszügen bestehen kann, die in dem vorgenannten Winkel zueinander stehen. Im intuitiv übertragenden Sinn wird also mit dem Finger zuerst der erste Betriebswert eingestellt und dann sozusagen zu der zweiten Funktion gebracht bzw. hingeschoben.

Bei der Erfindung wird der Finger bei der weiterführenden Bewegung, also im zweiten Bewegungszug, nicht bis ganz hin zu dem zweiten Symbol bzw. auf dieses bewegt, sondern nur in Richtung auf das zweite Symbol zu, wobei mindestens 25% bis 50% der Strecke hin zu dem zweiten Symbol zurückgelegt werden, vorzugsweise 50% bis 75%. Dadurch kann noch einfacher und quasi noch eleganter das Zuordnen des ersten Betriebswertes zu der zweiten Funktion erfolgen, da die Bedieneinrichtung bereits diese zweite Bewegungsrichtung der weiterführenden Bewegung erkennt als auf das entsprechende Symbol gerichtet und diese dann nicht unbedingt bis auf das entsprechende Symbol geführt werden muss.

Zur Darstellung der Symbole kann unter der Bedienfläche eine großflächige Anzeige vorgesehen sein, welche einen Großteil bzw. mindestens 50% oder 60% der Bedienfläche einnimmt. Vorteilhaft sind dies mindestens 75% bzw. unter Umständen sogar die gesamte Bedienfläche. Es können unter Umständen auch weitere Symbole auf die Bedienfläche fest aufgebracht bzw. aufgedruckt sein. Des Weiteren ist es mit einer großflächigen Anzeige möglich, eine Bewegung des Fingers darzustellen bzw. nachzuverfolgen zur Anzeige und Rückmeldung an die Bedienperson. So weiß diese stets, welche Stelle des angenäherten oder aufgelegten Fingers die Bedieneinrichtung erkennt bzw. erkannt hat und als Bewegung nachvollzieht. So kann quasi eine wiederum intuitive Kontrolle der Bedienbewegung bzw. der Bedienung erfolgen.

Des Weiteren ist zur Erkennung des Annäherns oder Auflegens eines Fingers einer Bedienperson eine Sensorik an der Bedienfläche vorgesehen, welche dies für große Bereiche, unter Umständen sogar im Wesentlichen die gesamte Bedienfläche, erkennen kann. Dies können längliche, in mehrere einzelne Felder unterteilte Sensoren sein und sogenannte "sensor arrays", also eine Vielzahl die Fläche einnehmender Sensoren. Diese können beispielsweise kapazitiv sein, wie es aus der DE 10026058 A1 bekannt ist und mit leichtem Druck arbeiten, wozu vorteilhaft Piezo-Sensoren vorgesehen sein können. Ein Beispiel hierfür ist die DE 10 2008 033 369 A1. Zusammen mit den Sensorelementen bzw. Berührsensoren kann ein bekannter Touch-Screen als Anzeige bzw. für die Bedienfläche verwendet werden.

In nochmals weiterer Ausgestaltung der Erfindung kann vorgesehen sein, dass durch die Anzeige dargestellt wird, dass nun ein Symbol bzw. ein länglicher Bereich, wie er zuvor beschrieben worden ist, ausgewählt ist bzw. zum Einstellen seines Betriebswertes bereit ist. Dies kann beispielsweise durch hellere Beleuchtung oder eine dynamische Beleuchtung oder Farbwechsel erfolgen. Auch dies verbessert eine intuitive Benutzerführung.
In nochmals weiterer Ausgestaltung der Erfindung kann vorgesehen sein, als einzustellende Funktion einen zwei- oder mehrstelligen Leistungswert bzw. Zahlenwert als Betriebswert einzustellen. Dazu wird ein Finger durch eine vorbeschriebene ziehende Bewegung bzw. einen Bewegungszug entlang einer Linie bewegt und je nach Stellung wird ein Zahlenwert eingestellt, der dann als erste Stelle bestimmt werden kann. Dieses Bestimmen als erste Stelle kann dadurch erfolgen, dass der Finger nach Einstellen dieses Zahlenwertes direkt zu einem weiteren Symbol bewegt wird, welches sozusagen diese erste Stelle repräsentiert. An diesem Symbol wird dann vorteilhaft der Zahlenwert für diese erste Stelle gezeigt. Dann kann der Finger abgenommen werden und erneut durch eine zweite aufgesetzte ziehende Bewegung wie zuvor beschrieben ein weiterer Zahlenwert eingestellt werden und als weitere Stelle durch eine weitere aufgesetzte ziehende Bewegung einem Symbol zugeordnet werden, welches neben dem vorgenannten Symbol angeordnet ist. So kann eine zwei- bzw. mehrstellige Zahl sozusagen Stelle für Stelle aus jeweils wiederum gleichartig ausgewählten Zahlenwerten mit mehreren Bewegungszügen zusammengesetzt werden.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig.1: eine Draufsicht auf ein Kochfeld als Gerät mit einer erfindungsgemäßen Bedieneinrichtung,
- Fig. 2 und 3: eine erfindungsgemäße Bedieneinrichtung in größerer Darstellung mit zwei Varianten von Berührerkennung und
- Fig. 4 bis 9: verschiedene grafische Darstellungen von Berührbewegungen bzw. Bedienungen einer der Bedieneinrichtung gemäß Fig. 2 oder 3.

### Detaillierte Beschreibung der Ausführungsbeispiele

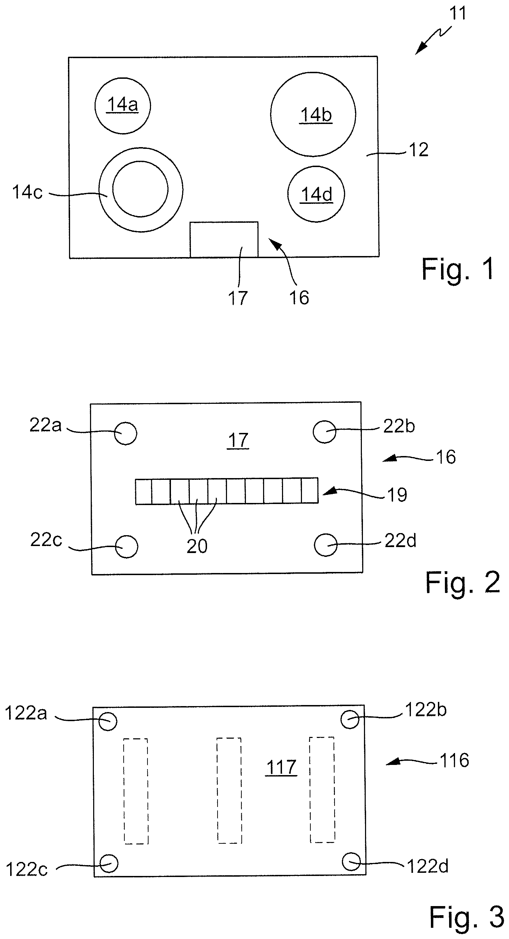

In Fig. 1 ist ein Kochfeld 11 als vorbeschriebenes Gerät in Draufsicht dargestellt, um die Erfindung zu erläutern. Das Kochfeld 11 weist eine Kochfeldplatte 12 sowie vier Kochstellen 14a bis 14d auf. Die Kochstelle 14c vorne links ist eine sogenannte Zweikreis-Kochstelle mit einem kleineren inneren Kreis und einem größeren, zuschaltbaren äußeren Kreis. Im vorderen Bereich ist mittig eine Bedieneinrichtung 16 mit Bedienfläche 17 vorgesehen. Diese kann als separates Teil in einen entsprechenden Ausschnitt in der Kochfeldplatte 12 eingesetzt sein. Alternativ und bevorzugt ist ein entsprechend ausgewählter Bereich der Kochfeldplatte 12 dazu vorgesehen, möglicherweise mit einer Umrandung, welche beispielsweise durch eine Bedruckung oder sonstwie optisch dargestellt werden kann.

In Fig. 2 ist in Vergrößerung eine erste Ausgestaltung einer erfindungsgemäßen Bedieneinrichtung 16 dargestellt, wie sie bei dem Kochfeld 11 in Fig. 1 verwendet werden kann. Unter der Bedienfläche 17 sind verschiedene Berührsensoren vorgesehen, unter anderem ein zentraler, streifenartiger Berührsensorstreifen 19, der in mehrere einzelne Segmente 20 unterteilt ist. Ein solcher Berührsensorstreifen 19 als sogenannter Slider ist beispielsweise aus der vorgenannten DE 10 2005 018 298 A1 oder DE 10 2009 049 559 A1 bekannt, auf welche diesbezüglich ausdrücklich verwiesen wird. Des Weiteren sind vier einzelne Berührsensoren 22a bis 22d vorgesehen, welche zueinander eine Verteilung annähernd wie die Kochstellen 14a bis 14d am Kochfeld 11 haben. Diese Berührsensoren können auch an der Oberseite der Bedienfläche durch entsprechende aufgedruckte Symbole markiert sein.

In Fig. 3 ist eine alternative Bedieneinrichtung 116 dargestellt mit einer Bedienfläche 117, die ebenfalls, wie zuvor erläutert, Bestandteil des Kochfeldes 11 aus Fig. 1 sein kann. In den vier Ecken der Bedienfläche 117 sind wiederum Berührsensoren 122a bis 122d angeordnet. Eine solche Bedieneinrichtung 116 ist beispielsweise aus der DE 10026058 A1 bekannt, auf welche diesbezüglich ausdrücklich verwiesen wird. Während bei der Fig. 2 der Berührsensorstreifen 19 mit seinen Segmenten 20 bzw. die Berührsensoren 22a bis 22d dadurch bedient bzw. ausgelöst werden, dass ein Finger direkt über ihnen auf die Bedienfläche 17 aufgelegt oder daran angenähert wird, können die Berührsensoren 122a bis 122d durch ihre Ausbildung und Steuerung das Auflegen bzw. Vorhandensein eines Fingers an einem beliebigen Punkt auf der Bedienfläche 117 erkennen. Somit können weitaus mehr verschiedene und vor allem frei definierbare Bedienungen erkannt werden.

Des Weiteren befindet sich unter den Bedienflächen 17 bzw. 117 der Bedieneinrichtungen 16 bzw. 116 gemäß der Fig. 2 bzw. 3 auch noch nicht dargestellte Anzeigen. Diese können entweder einzelne diskrete Symbole oder Flächen anzeigen, wie nachfolgend noch erläutert. Alternativ können es sozusagen Bildschirme für frei wählbare Darstellungen sein, insbesondere als vorgenannte Touch Screens.

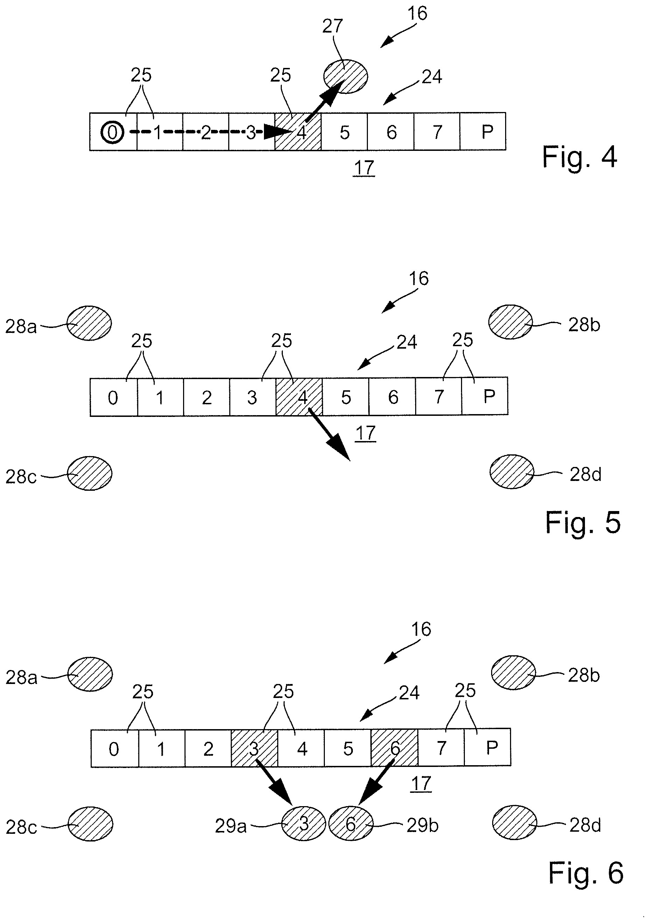

In Fig. 4 ist für die Bedieneinrichtung 16 entsprechend Fig. 2 ein erfindungsgemäßes Verfahren bzw. eine Bedienmöglichkeit dargestellt. An der Bedienfläche 17 ist ein sogenannter Slider 24 dargestellt mit neun einzelnen Slider-Segmenten 25, in denen jeweils eine Zahl von 0 bis 7 und ganz rechts der Buchstabe "P" als Symbol dargestellt ist. Dies steht für verschiedene Leistungsstufen für eine der Kochstellen 14 des Kochfeldes 11 gemäß Fig. 1. Der Buchstabe P steht für eine besonders hohe Leistung, eine sogenannte Boost-Leistung. Der Slider 24 mit den Slider-Segmenten 25 kann entweder durch die vorgenannte Anzeige an der Bedienfläche 17 dargestellt werden und möglicherweise auch verändert werden. Alternativ kann er durch eine Bedruckung der Oberfläche der Bedienfläche 17 erzeugt sein.

Gemäß einem ersten nicht erfindungsgemäßen Verfahren wird ein Finger oberhalb des Slider-Segments 25 mit der "4" aufgelegt, wodurch eine Leistungsstufe "4" direkt eingestellt wird. Dann wird, wie durch den Pfeil veranschaulicht ist, der Finger auf der Bedienfläche 17 aufgesetzt nach rechts oben gezogen ein Stück, beispielsweise 2 cm bis 3 cm. Dies bedeutet, dass eine Bedienperson diese Leistungsstufe "4" einem weiteren Symbol 27, welchem ein weiterer, nicht dargestellter Berührsensor entspricht, zuordnen möchte. Die Bedieneinrichtung 16 samt nicht dargestellter Steuerung erkennt also zuerst das Auflegen des Fingers oberhalb des Slider-Segments 25, welches dem entsprechen Segment 20 des Berührsensorstreifens 19 entsprechend Fig. 2 entspricht. Als nächstes erkennt sie, dass sich der Finger dem Symbol 27 bzw. einem zugehörigen Berührsensor nähert und schließlich darüber aufliegt. Dies wird dann in den Befehl umgewandelt, die genannte Leistungsstufe "4" dem Symbol 27 bzw. einer möglichen Funktionseinheit zuzuordnen. Dies wird nachfolgend noch näher erklärt, insbesondere mit Bezug auf die einzelnen Kochstellen. Dieses Verfahren entspricht somit dem im Anspruch 1 beschriebenen Verfahren gemäß der ersten grundsätzlichen Ausgestaltung der Erfindung.

Bei dem beanspruchten Verfahren wird ein Finger gemäß dem dargestellten Kreis zuerst auf das ganz linke Slider-Segment 25 aufgesetzt und dann in einem ersten Bewegungszug entsprechend dem gestrichelten Pfeil nach rechts bewegt wird auf der Bedienfläche 17 bis über das Slider-Segment "4". Es kann also an den Segmenten 25 des Berührsensorstreifens 24 erkannt werden, dass der Finger an den entsprechenden Slider-Segmenten 25 mit den Ziffern "0" bis "4" aufgelegt und bewegt worden ist. Von dem Slider-Segment 25 mit der Ziffer "4" wird dann der Finger in einem zweiten Bewegungszug entsprechend dem Pfeil nach rechts oben bewegt. Dieses Verfahren entspricht zum einen der klassischen Slider-Bedienung, wie sie der zuvor genannten DE 10 2005 018 298 A1 oder DE 10 2009 049 559 A1 zu entnehmen ist, zumindest mit dem ersten Bewegungszug. Die Kombination der beiden Bewegungszüge mit dem Winkel von etwa 130° dazwischen entspricht der zweiten grundsätzlichen Ausgestaltung der Erfindung gemäß dem Verfahrensanspruch 1. In Fig. 5 ist mit Bezug auf das Kochfeld 11 für die Bedieneinrichtung 16 entsprechend Fig. 2 eine Bedienung ähnlich Fig. 4 dargestellt. Hier sind vier Symbole 28a dargestellt, wie sie entsprechend Fig. 2 genau über den Berührsensoren 22a bis 22d vorhanden sind. Ähnlich wie der zentrale Slider 24 mit seinen einzelnen Segmenten 25 können sie dynamisch durch eine Anzeige oder durch Aufdrucke dargestellt werden.
Der Pfeil, der von dem Slider-Segment 25 mit der Ziffer "4" aus nach rechts unten geht, entspricht einem zu Fig. 4 grundsätzlich erläuterten Bewegungszug mit auf die Bedienfläche 17 aufgelegtem Finger. Der Finger kann dabei entweder direkt auf dieses Slider-Segment 25 aufgelegt und dann nach rechts unten auf das Symbol 28d zu bewegt werden.

Alternativ kann er von dem Slider-Segment 25 mit der Ziffer "0" dorthin bei aufgelegtem Finger gezogen werden, also eine Bedienung mit zwei Bewegungszügen erfolgen. Der Berührsensor 22d, der unter dem Symbol 28d liegt, kann erkennen, wenn sich der auf die Bedienfläche 17 aufgelegte Finger annähert. Somit wird hier die Leistungsstufe 4, die zuvor ausgewählt worden ist, der Kochstelle 14d zugeordnet, welche steuerungstechnisch und auch von der Anordnung her dem Berührsensor 22d entspricht. So wird also nach Auswahl der Leistungsstufe "4" dieser Wert für den Betrieb der Kochstelle 14d zugeordnet. Unmittelbar im Anschluss daran beginnt die Kochstelle 14d mit diesem Betrieb, was der Bedienperson möglicherweise noch durch eine optische und/oder akustische Signalisierung angezeigt werden kann.

Es ist leicht zu erkennen, dass mit dem in Fig. 5 dargestellten Verfahren eine beliebige Leistungsstufe jeder der Kochstellen 14a bis 14d zugeordnet werden kann durch Auswählen der Leistungsstufe und Hinziehen zu einem der Symbole 28a bis 28d über den Berührsensoren 22a bis 22d, welche eben den von der Position her entsprechenden Kochstellen zugeordnet sind. Dabei kann dieses Hinziehen entweder bis direkt zu dem Symbol 28a bis 28d erfolgen oder aber es kann bereits der halbe Weg oder sogar noch etwas weniger ausreichen. Entweder können dies dann die Berührsensoren 22a bis 22d selbst erkennen oder aber es sind noch weitere Berührsensoren vorgesehen ohne entsprechende Symbole an der Bedienfläche 17. Besonders vorteilhaft ist hier natürlich die Variante entsprechend der Fig. 3, bei der quasi an jeder Stelle an der Bedienfläche erkannt werden kann, dass dort ein Finger aufgelegt worden ist oder sich befindet bzw. dorthin bewegt worden ist.

In Fig. 6 ist ein weiteres Verfahren dargestellt, um als Gerät das Kochfeld 11 zu steuern. Hier ist beschrieben, wie beispielsweise für eine Timer-Eingabe als Funktion ein Betriebswert, nämlich die Timer-Dauer, eingestellt wird. In einem ersten Schritt wird mit einem der beiden zuvor beschriebenen, grundsätzlichen Verfahren ein Zahlenwert "3" ausgewählt und in einem Bewegungszug nach unten gezogen zu einem Symbol 29a. Möglicherweise kann dieser Zahlenwert "3" durch eine entsprechende Anzeige an der Bedieneinrichtung 16 dargestellt werden, wie es in Fig. 6 zu erkennen ist. In einem zweiten Schritt wird dann ein weiterer Zahlenwert "6" ausgewählt und dem rechten Symbol 29b zugeordnet durch eine weitergeführte Bewegung des Fingers von dem Slider-Segment 25 mit der Ziffer "6" hin zu dem Symbol 29b. Dadurch wird als Betriebswert die zweistellige Zahl "36" ausgewählt für den Timer-Betrieb. Dieser kann dann direkt einsetzen oder aber nach einer weiteren Bedienaktion, welche leicht vorstellbar ist und deswegen hier nicht näher erläutert werden muss.

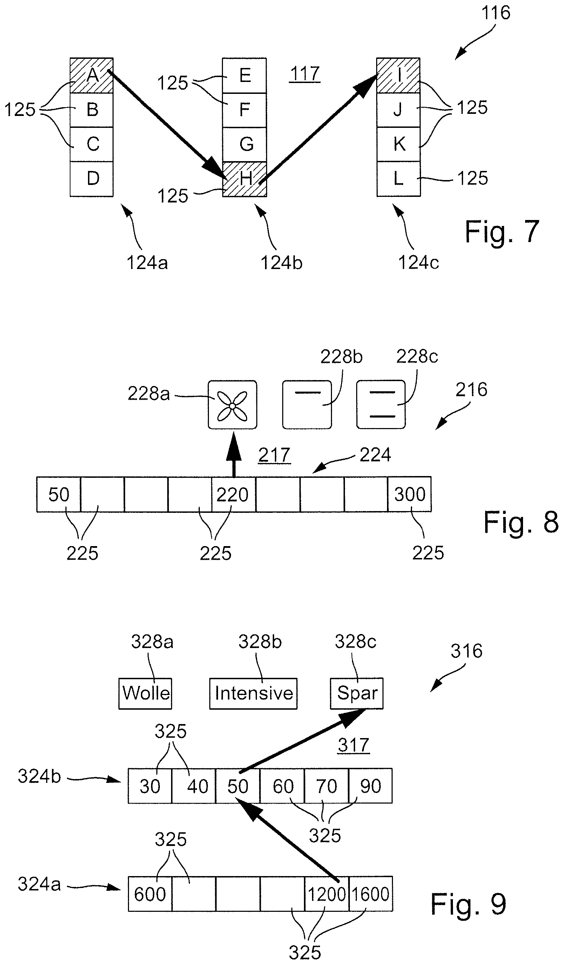

In Fig. 7 ist dargestellt, dass auf einer Bedienfläche 117 einer Bedieneinrichtung 116, wie sie vorteilhaft entsprechend Fig. 3 ausgebildet ist, drei Slider 124a bis 124c als Symbol dargestellt sind, vorteilhaft durch eine Anzeige. Diese sind bereits bei der Fig. 3 durch die Strichlierung angedeutet. Hier beginnt ein Verfahren zur Steuerung eines nicht näher dargestellten Gerätes, wie es in Fig. 7 dargestellt ist, durch Aufsetzen eines Fingers auf das oberste Slider-Segment 125 des linken Sliders 124a. Somit wird eine bestimmte Funktion der erste Betriebswert "A" eingestellt, beispielsweise eine bestimmte Grund-Betriebsart des Gerätes.

Dann wird der auf die Bedienfläche 17 aufgesetzte Finger in einem Bewegungszug zu dem untersten Slider-Segment 125 des mittleren Sliders 124b gezogen, bis er sich direkt darüber befindet. Somit wird als zweiter Betriebswert die entsprechende Funktion "H" ausgewählt. Auch dies kann der Bedienperson akustisch und/oder optisch angezeigt werden. Der weiterhin aufgesetzte Finger wird dann wiederum nach rechts oben zu dem obersten Slider-Segment 125 des rechten Sliders 124c gezogen, bis er direkt darüber aufliegt. Somit wird schließlich als letztes der entsprechende Betriebswert "I" ausgewählt und eingestellt. Bei diesem Bedienverfahren erfolgt also ein Richtungswechsel bei zwei Bewegungszügen.

In Fig. 8 ist in Anlehnung an das grundsätzliche Verfahren entsprechend Fig. 7 ein Beispiel dargestellt, wie mit der Bedieneinrichtung 216 und der Bedienfläche 217 ein nicht näher beschriebener Backofen bedient werden kann. Auch hier entspricht die Bedieneinrichtung 216 wiederum im Wesentlichen derjenigen aus Fig.3.

An einem horizontalen Slider 224 mit mehreren Slider-Segmenten 225 werden verschiedene Temperaturstufen von "50" bis 300" für 50°C bis 300°C angegeben. Darüber befinden sich drei nebeneinander angeordnete Symbole 228a bis 228c, welche die Betriebsarten "Umluft", "Oberhitze" und "Unter- + Oberhitze" bedeuten. Die dargestellte Bewegung als Bedienung beginnt bei dem fünften Slider-Segment 225 von links mit einem entsprechenden Temperaturwert von "220". Der Finger kann entweder direkt auf dieses Slider-Segment 225 aufgelegt werden oder aber in einem Bewegungszug ganz links beginnend dort hingezogen worden sein. Jedenfalls geht er von dort in einer auf die Bedienfläche 217 aufgelegten Bewegung als Bewegungszug zu dem linken Symbol 228a für "Umluft". Somit wird also eine Backofentemperatur von 220°C ausgewählt und mit der Betriebsart "Umluft" verknüpft, um den Betrieb des Backofens auf diese Art und Weise zu starten.

Eine nochmals weitere Möglichkeit zur Bedienung ist in Fig. 9 dargestellt mit einer Bedieneinrichtung 316 samt Bedienfläche 317, welche ähnlich aufgebaut ist wie in Fig. 7, nur um 90° verdreht ist und am besten auf die in Fig. 3 dargestellte Art und Weise realisiert ist. Dieses Bedienverfahren eignet sich für eine nicht näher beschriebene, aber leicht vorstellbare Waschmaschine.

An einem unteren Slider 324a wird zuerst das zweite Slider-Segment 325 von rechts mit einer Drehzahl "1200" ausgewählt, und zwar wiederum mit einem der beiden zuvor beschriebenen grundsätzlichen Verfahren. Dazu wird der Finger auf die Bedienfläche 317 gelegt. Im aufgelegten Zustand wird der Finger in einem ersten Bewegungszug zu dem zweiten Slider 324b darüber bewegt, und zwar auf das dritte Slider-Segment 325 von links mit einem Temperaturwert von "50". Diese Temperatur wird also als zweiter Betriebswert ausgewählt. Dann wird in einem weiterführenden zweiten Bewegungszug der Finger zu dem ganz rechten Symbol 328c geführt, und zwar entweder nur in dessen Richtung oder bis direkt darüber bzw. darauf. Damit wird die dem Symbol 328c zugeordnete Funktion "Spar" ausgewählt. Es wird also insgesamt ein Programm für die Waschmaschine eingestellt mit der Funktion "Spar", mit einer Temperatur von 50 C° und einer Drehzahl von 1200. Anschließend kann der Betrieb der Waschmaschine starten mit diesen Vorgaben.

## Patentansprüche

1. Verfahren zur Steuerung eines Geräts (11), wobei
- auf einer Bedienfläche (17, 117, 217, 317) einer Bedieneinrichtung (16, 116, 216, 316) des Gerätes ein erstes Symbol (27, 28, 228, 328) für einen ersten Betriebswert einer ersten Funktion dargestellt wird,
- in einer auf die Bedienfläche aufgesetzten Bewegung des Fingers durch Längsbewegung entlang einer Linie der erste Betriebswert der ersten Funktion dann eingestellt wird, wenn der Finger das erste Symbol (27, 28, 228, 328) erreicht,
- dann durch eine weiterführende Bewegung ohne Abnehmen des Fingers in einer Richtung in einem Winkel zwischen 30° und 150° zur bisherigen Bewegungsrichtung der Finger weiter bewegt wird auf ein zweites auf der Bedienfläche (17, 117, 217, 317) dargestelltes Symbol (29) zu, zur Zuordnung der eingestellten ersten Funktion zu der Funktionsbedeutung dieses zweiten Symbols,
- der Finger bei der weiterführenden Bewegung nicht bis ganz hin zu dem zweiten Symbol (29) bewegt wird sondern nur ausgehend von dem Punkt des Richtungswechsels in Richtung auf das zweite Symbol zu für mindestens 25 % bis 50%, vorzugsweise 50% bis 75%, der Strecke von dem Punkt des Richtungswechsels bis zu dem zweiten Symbol (29).

2. Verfahren nach Anspruch 1, **dadurch gekennzeichnet, dass** unter der Bedienfläche (17, 117, 217, 317) eine großflächige Anzeige angeordnet ist, welche mindestens 50% oder 60% der Bedienfläche einnimmt, und insbesondere die gesamte Bedienfläche einnimmt.

3. Verfahren nach Anspruch 2, **dadurch gekennzeichnet, dass** auf der Anzeige die Bewegung des Fingers dargestellt wird, insbesondere durch eine leuchtende Spur oder einen leuchtenden Punkt.

## Claims

1. Method for controlling an appliance (11), wherein
- on an operating control surface (17, 117, 217, 317) of an operating control device (16, 116, 216, 316) of the appliance a first symbol (27, 28, 228, 328) for a first operational value of a first function is displayed,
- the first operating value of the first function is set in a movement of the finger applied on the operating control surface, by means of a longitudinal movement along a line, when the finger reaches the first symbol (27, 28, 228, 328),
- then by means of a continued movement without removing the finger in a direction with an angle between 30° and 150° relative to the previous movement direction, the finger is moved on further towards a second symbol (29) displayed on the operating control surface (17, 117, 217, 317) for assigning the set first function to the functional meaning of said second symbol,
- during the continued movement the finger is not completely moved up to the second symbol (29), but only in the direction towards the second symbol, starting from the point of change in direction, for at least 25 % to 50 %, preferably 50 % to 75 %, of the distance from the point of change in direction up to the second symbol (29).

2. Method according to claim 1, **characterized in that** a large-area display is located underneath the operating control surface (17, 117, 217, 317), which covers at least 50 % or 60 % of the operating control surface, and in particular covers the entire operating control surface.

3. Method according to claim 2, **characterized in that** the movement of the finger is displayed on the display, in particular by means of an illuminated track or by means of an illuminated spot.

## Revendications

1. Procédé de commande d'un appareil (11), dans lequel
- un premier symbole (27, 28, 228, 328) pour une première valeur de fonctionnement d'une première fonction est représenté sur une surface de commande (17, 117, 217, 317) d'un dispositif de commande (16, 116, 216, 316) de l'appareil,
- la première valeur de fonctionnement de la première fonction est ajustée par un déplacement du doigt contre la surface de commande par un déplacement longitudinal le long d'une ligne lorsque le doigt atteint le premier symbole (27, 28, 228, 328),
- puis, en poursuivant le déplacement du doigt sans le retirer dans une direction suivant un angle compris entre 30° et 150° par rapport à la direction de déplacement d'origine, on continue de déplacer le doigt vers un deuxième symbole (29) représenté sur la surface de commande (17, 117, 217, 317) afin d'attribuer la première fonction ajustée à la signification de la fonction de ce deuxième symbole,
- lors de la poursuite du déplacement, le doigt n'est pas déplacé complètement jusqu'au deuxième symbole (29) mais seulement depuis le point de changement de direction dans la direction du deuxième symbole jusqu'à au moins 25 % à 50 %, de préférence 50 % à 75 % de la distance allant du point de changement de direction jusqu'au deuxième symbole (29).

2. Procédé selon la revendication 1, **caractérisé en ce qu'**un affichage de grande surface est prévu en dessous de la surface de commande (17, 117, 217, 317), lequel occupe au moins 50 % ou 60 % de la surface de commande, et occupe notamment toute la surface de commande.

3. Procédé selon la revendication 2, **caractérisé en ce que** le déplacement du doigt est représenté sur l'affichage, notamment par une marque lumineuse ou un point lumineux.
